# EUROPEAN PATENT SPECIFICATION

(11) **EP 4 328 564 B1**
(45) Date of publication and mention of the grant of the patent: **30.07.2025**
(21) Application number: 23184234.5
(22) Date of filing: 07.07.2023
(51) Int. Cl.: G01N 5/00, G01N 5/04, G01N 25/48

(54) **THERMOGRAVIMETRIC MEASUREMENT APPARATUS AND METHOD FOR SETTING THE SAME**
THERMOGRAVIMETRISCHE MESSVORRICHTUNG UND VERFAHREN ZU IHRER EINSTELLUNG
APPAREIL DE MESURE THERMOGRAVIMÉTRIQUE ET SON PROCÉDÉ DE RÉGLAGE

(30) Priority: 24.08.2022 JP 2022133093
(43) Date of publication of application: 28.02.2024
(73) Proprietor: Shimadzu Corporation, Nakagyo-ku, Kyoto-shi, Kyoto 604-8511 (JP)
(72) Inventor: TOMITA, Hajime, Kyoto-shi, 6048511 (JP); SHIMOJIMA, Kei, Kyoto-shi, 6048511 (JP)
(74) Representative: Mewburn Ellis LLP

(56) References cited:
- EP-A1- 1 114 308
- EP-A2- 2 700 942
- JP-A- 2003 240 625
- JP-A- 2021 032 748
- US-A1- 2008 049 809
- US-A1- 2021 055 194
- US-B1- 6 440 746

## Description

### BACKGROUND OF THE INVENTION

### Field of the Invention

The present invention relates to a thermogravimetric measurement apparatus and a method for setting the same.

### Description of Related Art

For example, JP2021-32624A discloses a thermogravimetric measurement apparatus that includes a sample plate on which a sample is to be placed, a balance connected to the sample plate, a heating unit adapted to heat the sample, and the like. This thermogravimetric measurement apparatus can measure changes in the weight of the sample placed on the sample plate while the sample is heated.

Such a thermogravimetric measurement apparatus includes a cooling fan to prevent the temperature of the apparatus body from increasing as the sample is heated. However, when the cooling fan rotates and vibrates, the weight measurement value may be different from the actual weight of the sample. That is, in this case, the weight measurement value and the weight waveform, which is the continuous weight measurement value, may include noise.

As for the balance, balances manufactured by the same method may still have mutually different natural frequencies. As for the cooling fan, cooling fans manufactured by the same method may still have mutually different vibration frequencies caused by rotation of a predetermined rotation speed. As such, with the thermogravimetric measurement apparatus, the amount of noise in the weight measurement value may vary from apparatus to apparatus even when the cooling fans are operated under the same conditions.

For these reasons, it is difficult to adjust the amount of noise in the weight measurement value caused by the rotation and vibration of the cooling fan in the thermogravimetric measurement apparatus as described above. Other documents of the prior art are EP1114308, EP2700942, JP2021032748 and JP2003240625.

### SUMMARY OF THE INVENTION

In view of the foregoing, it is an object of the present invention to provide a thermogravimetric measurement apparatus and a method for setting the same that allow for appropriate determination of the rotation speed in operation of a cooling fan for the individual apparatus.

A first aspect of the invention is a method for setting a thermogravimetric measurement apparatus as defined in claim 1.

A second aspect of the invention is a thermogravimetric measurement apparatus as defined in claim 7.

### BRIEF DESCRIPTION OF THE DRAWINGS

FIG. 1 is a schematic cross-sectional view showing an example of the configuration of a thermogravimetric measurement apparatus of an embodiment;
FIG. 2 is a block diagram showing an example of the electrical configuration of the thermogravimetric measurement apparatus of the present embodiment;
FIG. 3 is a schematic view showing an example of a weight waveform in a rotation speed determination step of the present embodiment;
FIG. 4 is a functional block diagram showing a specific example of the electrical configuration of the thermogravimetric measurement apparatus of the present embodiment; and
FIG. 5 is a flowchart showing an example of a setting process of the thermogravimetric measurement apparatus of the present embodiment.

### DETAILED DESCRIPTION OF THE INVENTION

### 1. Configuration of Thermogravimetric Measurement Apparatus

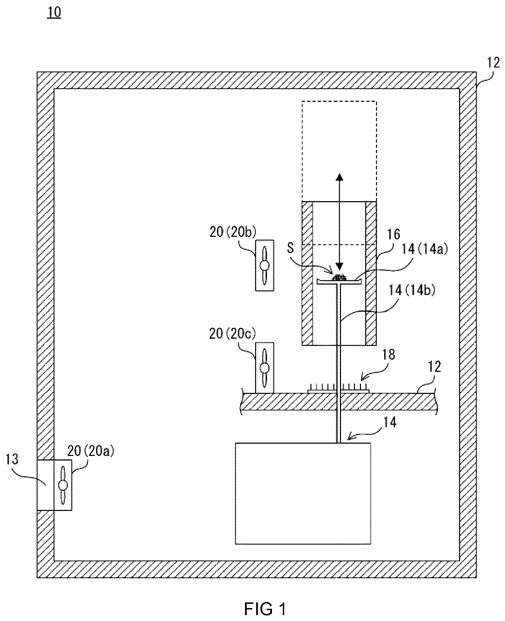

FIG. 1 is a schematic cross-sectional view showing an example of the configuration of a thermogravimetric measurement apparatus 10 of the present embodiment. The thermogravimetric measurement apparatus 10 is an apparatus for measuring changes in the weight of a sample S that occur when the sample S is heated, cooled, or maintained at a constant temperature, and is a concept that encompasses a simultaneous thermogravimetric/differential thermal analysis instrument.

The thermogravimetric measurement apparatus 10 may include a measurement unit 14, a heating unit 16, a heat radiation portion 18, and cooling fans 20 which are housed inside a housing 12. The housing 12 has an exhaust port 13 for exhausting air in the housing 12.

The measurement unit 14 measures the weight of the sample S. The measurement unit 14 is a top-loading thermobalance and thus includes a sample holder 14a and a support member 14b which supports the sample holder 14a. The measurement unit 14 can obtain weight measurement values. For example, when the sample S is set on the sample holder 14a as shown in FIG. 1, a weight measurement value indicating the weight of the sample S can be obtained.

The measurement unit 14 is directly or indirectly attached to the housing 12. For example, the measurement unit 14 may be attached to the housing 12 through various members for fixing the measurement unit 14 to the housing 12.

The heating unit 16 is an electrically controllable furnace and heats the sample S. The heating unit 16 is arranged above the measurement unit 14. The thermogravimetric measurement apparatus 10 also includes an electrically controllable first displacement mechanism (not shown) which displaces the heating unit 16. The heating unit 16 can be vertically displaced by this first displacement mechanism.

In the present embodiment, when measuring changes in the weight of the sample S while heating the sample S, for example, the heating unit 16 is placed at a position at which the sample S is housed in the heating unit 16 as shown in FIG. 1. When the sample S is set onto the sample holder 14a and when the sample S is removed from the sample holder 14a, the heating unit 16 is placed at a position at which the sample S is not housed in the heating unit 16, that is, at a position indicated by the broken line in FIG. 1.

The thermogravimetric measurement apparatus 10 includes a general-purpose temperature sensor (not shown), and the temperature of the heating unit 16 is controlled based on the temperature signal output from this temperature sensor.

The thermogravimetric measurement apparatus 10 also includes an electrically controllable second displacement mechanism (not shown) which displaces a portion of the housing 12. For example, a portion of the housing 12 that is lateral to the sample holder 14a can be opened and closed, or is slidable.

In the thermogravimetric measurement apparatus 10, when an operation reception unit (not shown) receives the first predetermined operation by the user, the first and second displacement mechanisms cooperate to allow the sample S to be set onto or removed from the sample holder 14a.

The heat radiation portion 18 is a member that absorbs heat and dissipates heat into the air. The heat radiation portion 18 may be a general-purpose heat sink, for example. The heat radiation portion 18 is provided around the support member 14b and below the heating unit 16.

The cooling fans 20 are electrically controllable axial fans. Each cooling fan 20 functions to cool the inside of the housing 12 or to cool components of the thermogravimetric measurement apparatus 10.

Also, each cooling fan 20 is directly or indirectly attached to the housing 12 in the same manner as the measurement unit 14. In other words, the cooling fan 20 is physically connected to the measurement unit 14.

The cooling fans 20 include a first cooling fan 20a, a second cooling fan 20b, and a third cooling fan 20c.

The first cooling fan 20a cools the inside of the housing 12 by discharging the heated air inside the housing 12 to the outside of the housing 12 through the exhaust port 13. The first cooling fan 20a is always in operation. Thus, while the weight of the sample S is measured, the first cooling fan 20a is in operation.

The second cooling fan 20b cools the heating unit 16. The second cooling fan 20b is stopped while the sample S is heated and is operated as necessary when the sample S is not being heated.

The third cooling fan 20c cools the heat radiation portion 18. The third cooling fan 20c is stopped while the sample S is set onto the sample holder 14a or removed from the sample holder 14a. Also, the third cooling fan 20c is in operation at least while the weight of the sample S is measured.

The cooling fans 20 may include fans other than the first cooling fan 20a, the second cooling fan 20b, and the third cooling fan 20c. For example, when the housing 12 has an inlet port, the cooling fans 20 may include a fan for introducing air into the housing 12 from the outside of the housing 12 through the inlet port.

The thermogravimetric measurement apparatus 10 can measure changes in the weight that occur while the sample S on the sample holder 14a is heated, cooled, or maintained at a constant temperature. It should be noted that the configuration of the thermogravimetric measurement apparatus 10 shown in FIG. 1 is merely an example.

Regarding the thermogravimetric measurement apparatus 10, components other than the measurement unit 14 may be provided outside the housing 12 as long as they can function as described above. In other words, the thermogravimetric measurement apparatus 10 of the present embodiment may have a configuration in which at least the measurement unit 14 is provided inside the housing 12.

Also, in the thermogravimetric measurement apparatus 10 of the present embodiment, a cooling fan 20 may be physically connected to the measurement unit 14 without the housing 12 interposed therebetween. That is, the cooling fan 20 may be directly attached to the measurement unit 14 or may be attached to the measurement unit 14 through a certain member.

Furthermore, the measurement unit 14 of the present embodiment may be a suspension thermobalance or a horizontal thermobalance. The displacement direction of the heating unit 16 is set in accordance with the method of thermobalance.

### 2. Electrical Configuration of Thermogravimetric Measurement Apparatus

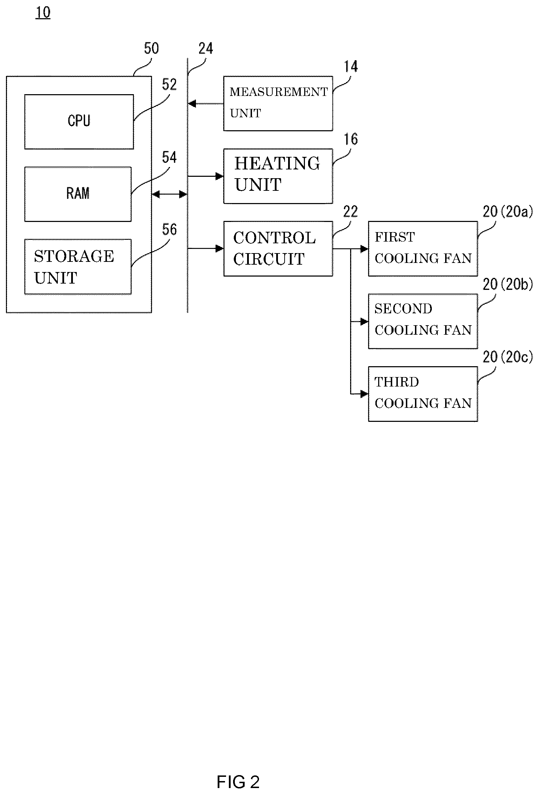

FIG. 2 is a block diagram showing an example of the electrical configuration of the thermogravimetric measurement apparatus 10 of the present embodiment. In addition to the measurement unit 14, for example, the thermogravimetric measurement apparatus 10 includes a control circuit 22 and a control unit 50.

The control unit 50, the measurement unit 14, the heating unit 16, the control circuit 22, and the like are electrically connected to one another via a circuit 24 such as a bus. The control circuit 22 is also electrically connected to the first cooling fan 20a, the second cooling fan 20b, and the third cooling fan 20c.

The control circuit 22 is a circuit for controlling the operation of each cooling fan 20. The control circuit 22 adjusts the control conditions of the cooling fan 20, that is, the parameters that determine the rotation speed of the cooling fan 20 according to instructions from the control unit 50. For example, the control circuit 22 appropriately adjusts the voltage applied to the cooling fan 20 or the pulse signal transmitted to the cooling fan 20.

The control unit 50 performs the overall control of the thermogravimetric measurement apparatus 10. The control unit 50 includes a central processing unit (CPU) 52. The control unit 50 also includes a random access memory (RAM) 54 and a storage unit 56, which can be directly accessed by the CPU 52.

The RAM 54 is used as a work area and a buffer area for the CPU 52. A non-volatile memory such as a hard disc drive (HDD) or a solid state drive (SSD) is used as the storage unit 56.

The storage unit 56 stores a program (control program) for controlling the operation of the thermogravimetric measurement apparatus 10, data required for executing the control program (execution data), and the like. The storage unit 56 may also be configured to include the RAM 54.

### 3. Operation of Thermogravimetric Measurement Apparatus

In the thermogravimetric measurement apparatus 10, the measurement unit 14 and the cooling fans 20 are physically connected, and the vibration caused by the rotation of the cooling fans 20 thus propagates to the measurement unit 14. This may cause the weight measurement value to be different from the actual weight of the sample S. That is, the weight measurement value and the continuous weight measurement value (weight waveform) may include noise.

As for the measurement unit 14, measurement units that are manufactured by the same method may still be susceptible to mutually different vibration frequencies, that is, may have mutually different natural frequencies. As for the cooling fans 20, cooling fans that are manufactured by the same method may still have mutually different vibration frequencies with respect to the rotation speed.

As such, as for the thermogravimetric measurement apparatus 10, the amount of noise in the weight measurement value may vary from apparatus to apparatus even when the cooling fans 20 are operated under the same conditions. For example, in the thermogravimetric measurement apparatus 10, the rotation speed of the cooling fan 20 with which the amount of noise in the weight measurement value is considered the smallest may vary from apparatus to apparatus.

Thus, with the thermogravimetric measurement apparatus 10, it is difficult to adjust the amount of noise in the weight measurement value caused by the rotation and vibration of the cooling fans 20.

For this reason, the thermogravimetric measurement apparatus 10 is configured to be capable of performing a rotation speed setting process at any given time. The rotation speed setting process identifies the relationship between the rotation speed of the cooling fan 20 and the amount of noise in the weight measurement value caused by the vibration of the cooling fan 20 and then sets a rotation speed in operation of the cooling fan 20.

Here, the cooling fan 20 in operation refers to that the cooling fan 20 is in operation other than the rotation speed setting process. As such, the rotation speed in operation of the cooling fan 20 includes, for example, the rotation speed of the cooling fan 20 in a situation in which the sample S on the sample holder 14a is heated, cooled, or maintained at a constant temperature while changes in the weight of the sample S are measured.

Also, determining the control conditions of the cooling fan 20 determines the rotation speed of the cooling fan 20. As such, the rotation speed of the cooling fan 20 may also be considered as a control condition of the cooling fan 20. In this respect, the rotation speed in operation of the cooling fan 20 may be considered as a control condition of the cooling fan 20 in operation.

The parameter that determines the control conditions of the cooling fan 20 may be the voltage applied to the cooling fan 20 or the pulse signal transmitted to the cooling fan 20 as described above.

The rotation speed setting process is automatically executed before the weight of the sample S is measured, for example when the power of the thermogravimetric measurement apparatus 10 is switched from off to on. The rotation speed setting process may also be performed when the thermogravimetric measurement apparatus 10 receives the second predetermined operation by the user at the above-mentioned operation reception unit.

In the present embodiment, when the rotation speed setting process starts, the rotation speed determination step is performed one or more times.

The rotation speed determination step monitors changes in the weight measurement value at the measurement unit 14 while altering the rotation speed of a cooling fan 20, and determines the rotation speed in operation of the cooling fan 20 based on the changes in the weight measurement value.

The beating caused by vibrations of the multiple cooling fans 20 can be ignored because the natural frequency of the measurement unit 14 does not change. Furthermore, when multiple cooling fans 20 are operated, it is difficult to identify the cooling fan 20 that affects the weight measurement value.

For this reason, when there are multiple cooling fans 20, the rotation speed determination step monitors changes in the weight measurement value at the measurement unit 14 while altering the rotation speed of one of the multiple cooling fans 20 with the other cooling fans 20 stopped. In this case, the rotation speed determination step is repeatedly performed while switching the target cooling fan 20.

The present embodiment can also obtain a negative weight measurement value because the measurement unit 14 is a thermobalance. As such, the rotation speed determination step is performed in a state in which the sample S is not set on the sample holder 14a.

On the other hand, since the weight of the measurement unit 14 itself is substantially greater than the weight of the sample S, the presence or absence of the sample S does not affect the amount of noise in the weight measurement value. As such, the rotation speed determination step may also be performed with the sample S set on the sample holder 14a.

When the rotation speed determination step is performed in a state in which the sample S is not set on the sample holder 14a, the weight measurement value itself corresponds to the amount of noise. That is, in this case, the amount of noise in the weight measurement value can be easily identified. The rotation speed determination step is therefore preferably performed in a state in which the sample S is not set on the sample holder 14a.

Also, the rotation speed determination step alters the rotation speed of the cooling fan 20 in ascending order. However, the rotation speed determination step may alter the rotation speed of the cooling fan 20 in descending order. There is no limitation to the range of alteration of the rotation speed of the cooling fan 20 in the rotation speed determination step.

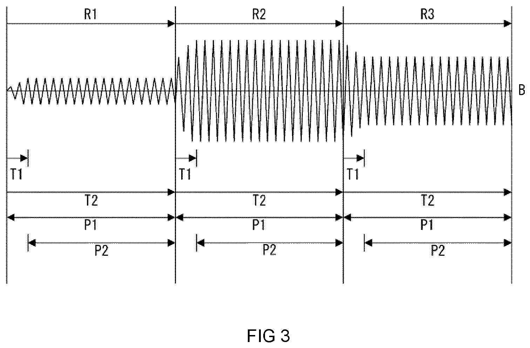

FIG. 3 is a schematic diagram showing an example of a weight waveform in the rotation speed determination step of the present embodiment. In the present embodiment, each cooling fan 20 is an electrically controllable component, and a response time T1 is needed between when the cooling fan 20 is controlled to alter its rotation speed and when the rotation speed of the cooling fan 20 becomes stable.

Thus, the response time T1 is needed between when the cooling fan 20 is controlled to alter its rotation speed and when a weight measurement value is obtained in a state in which the rotation speed of the cooling fan 20 is stable.

As such, if the rotation speed of the cooling fan 20 is continuously altered, it is difficult to identify the weight measurement value corresponding to the rotation speed, and a weight measurement value in a state in which the rotation speed of the cooling fan 20 is stable is not obtained.

For this reason, the rotation speed determination step monitors changes in the weight measurement value at the measurement unit 14 while altering the rotation speed of the cooling fan 20 in a stepwise manner.

When the rotation speed of the cooling fan 20 is altered in a stepwise manner, the rotation speed of the cooling fan 20 is altered each time a rotation speed maintaining time T2 elapses. To obtain a weight measurement value in a state in which the rotation speed of the cooling fan 20 is stable, the rotation speed maintaining time T2 is preferably longer than the response time T1. For example, in the rotation speed determination step, the rotation speed of the cooling fan 20 is altered every minute.

In the rotation speed determination step, when changes in the weight measurement value at the measurement unit 14 are monitored, the rotation speed in operation of the cooling fan 20 is determined based on the magnitude of the weight measurement value in a reference period P2 within a period P1 in which the rotation speed of the cooling fan 20 is maintained (rotation speed maintaining period).

The rotation speed maintaining period P1 is a period corresponding to a rotation speed maintaining time T2. The maximum of the reference period P2 is the same as the rotation speed maintaining period P1. The reference period P2 is preferably a period after the response time T1 in the rotation speed maintaining period P1 has elapsed, that is, a period after the rotation speed of the cooling fan 20 becomes stable.

Specifically, the rotation speed determination step refers to the magnitude of the weight measurement value in the reference period P2 for each rotation speed maintaining period P1, that is, for each rotation speed. In other words, the rotation speed determination step refers to a peak-to-peak value of the weight waveform within the reference period P2 for each rotation speed. The peak-to-peak value refers to the difference (divergence amount) between the maximum value and the minimum value of the weight waveform.

The magnitude of the peak-to-peak value of the weight waveform is proportional to the amount of noise in the weight waveform. Thus, when the accuracy of the weight measurement value is given a high priority, the step may refer to the peak-to-peak value of the weight waveform for each rotation speed, and determine, as the rotation speed in operation of the cooling fan 20, the rotation speed with which the amount of noise in the weight measurement value is considered the smallest. In the example shown in FIG. 3, rotation speed R1 may be determined as the rotation speed in operation of the cooling fan 20.

When a permissible amount of noise in the weight measurement value is predetermined, one of the rotation speeds with which the amounts of noise in the weight measurement values are less than or equal to the permissible amount may be determined as the rotation speed in operation of the cooling fan 20.

For example, when the cooling efficiency of the thermogravimetric measurement apparatus 10 is given a high priority, the highest rotation speed of the rotation speeds with which the amounts of noise in the weight measurement values are less than or equal to the permissible amount may be determined as the rotation speed in operation of the cooling fan 20.

Furthermore, instead of the peak-to-peak value of the weight waveform, the amplitude of the weight waveform, specifically, the difference between the maximum absolute value of the weight waveform and a reference value B may be referred to. Here, the reference value B is a weight measurement value indicating the weight of the sample S when the sample S is set on the sample holder 14a, and is 0 when the sample S is not set on the sample holder 14a.

Also, in the rotation speed determination step, when changes in the weight measurement value at the measurement unit 14 are monitored, the rotation speed in operation of the cooling fan 20 may be determined based on the average value of the weight measurement values in the reference period P2 within the rotation speed maintaining period P1.

Specifically, in this case, the rotation speed determination step refers to the average value of the weight measurement values in the reference period P2 for each rotation speed maintaining period P1, that is, for each rotation speed. In other words, the rotation speed determination step refers to the average value of the weight waveform in the reference period P2 for each rotation speed.

The difference between the average value of the weight waveform and the reference value B is proportional to the amount of noise in the weight waveform. As such, when the accuracy of the weight measurement value is given a high priority, the step may refer to the difference between the average value of the weight waveform for each rotation speed and the reference value B, and determine, as the rotation speed in operation of the cooling fan 20, the rotation speed with which the amount of noise in the weight measurement value is considered the smallest.

In this case, as described above, when the permissible amount of noise in the weight measurement value is predetermined, any one of the rotation speeds with which the amounts of noise in the weight measurement values are within the permissible range may be determined as the rotation speed in operation of the cooling fan 20.

In other words, when the cooling efficiency of the thermogravimetric measurement apparatus 10 is given a high priority, the highest rotation speed of the rotation speeds with which the amounts of noise in the weight measurement values are less than or equal to the permissible amount may be determined as the rotation speed in operation of the cooling fan 20 in the same manner.

When the rotation speed determination step determines the rotation speed in operation of the cooling fan 20 in this manner, the storage unit 56 stores rotation speed information indicating this rotation speed as data. When multiple cooling fans 20 are present, each piece of rotation speed information includes identification information that enables the identification of the associated cooling fan 20. A specific operation flow of the thermogravimetric measurement apparatus 10 is described below, using as an example a situation in which the rotation speed determination step is performed for the first cooling fan 20a.

In the present embodiment, when the rotation speed determination step is performed for the first cooling fan 20a, the second and third cooling fans 20b and 20c are stopped, and the rotation speed of the first cooling fan 20a is increased in a stepwise manner. While the rotation speed of the first cooling fan 20a is increased in a stepwise manner, changes in the weight measurement value at the measurement unit 14 are monitored.

When the monitoring of the weight measurement value at the measurement unit 14 is completed, the magnitude or average value of the weight measurement values in the reference period P2 is referred to for each rotation speed. The rotation speed with which the amount of noise in the weight measurement value is considered the smallest is determined as the rotation speed in operation of the first cooling fan 20a, for example.

When the rotation speed in operation of the first cooling fan 20a is determined in this manner, the storage unit 56 stores rotation speed information indicating this rotation speed as data. Also, in this case, the rotation speed information includes identification information indicating that this rotation speed information is associated with the first cooling fan 20a.

The thermogravimetric measurement apparatus 10 of the present embodiment refers to the rotation speed information when a rotation speed setting process is not in progress. In other words, in the thermogravimetric measurement apparatus 10 of the present embodiment, each cooling fan 20 rotates at the rotation speed determined in the rotation speed determination step, when the sample S is heated, cooled, or maintained at a constant temperature while changes in the weight of the sample S are measured.

### 4. Specific Example of Electrical Configuration of Thermogravimetric Measurement Apparatus

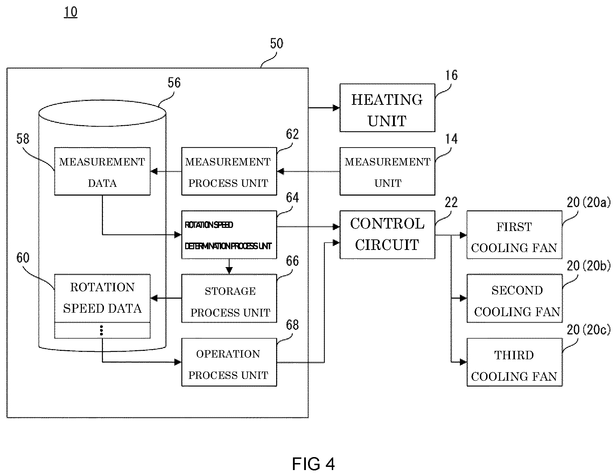

FIG. 4 is a functional block diagram showing a specific example of the electrical configuration of the thermogravimetric measurement apparatus 10 of the present embodiment. In FIG. 4, illustration of the RAM 54 and the like is omitted.

The storage unit 56 stores measurement data 58, rotation speed data 60, and the like. The measurement data 58 is data corresponding to weight measurement values. The measurement data 58 also corresponds to weight waveform.

The rotation speed data 60 is rotation speed information in a data format. The storage unit 56 may store multiple pieces of rotation speed data 60. The rotation speed data 60 may include data format identification information. Although illustration is omitted, the storage unit 56 also stores the control program, execution data, and the like as described above.

When the CPU 52 (see FIG. 2) runs the control program, the thermogravimetric measurement apparatus 10 may function as a measurement process unit 62, a rotation speed determination process unit 64, a storage process unit 66, and an operation process unit 68.

The measurement process unit 62 causes the storage unit 56 to store the weight measurement values obtained by the measurement unit 14 as measurement data 58.

The rotation speed determination process unit 64 functions to perform the rotation speed determination step. As such, the rotation speed determination process unit 64 monitors changes in the weight measurement value at the measurement unit 14 by referring to the measurement data 58 while altering the rotation speed of the cooling fan 20, and determines the rotation speed in operation of the cooling fan 20 based on the changes in the weight measurement value.

Specifically, the rotation speed determination process unit 64 monitors changes in the weight measurement value at the measurement unit 14 while altering the rotation speed of the cooling fan 20 in a stepwise manner.

Specifically, the rotation speed determination process unit 64 determines the rotation speed in operation of the cooling fan 20 based on the magnitude of the weight measurement values in the reference period P2 within the rotation speed maintaining period P1.

The rotation speed determination process unit 64 may also determine the rotation speed in operation of the cooling fan 20 based on the average value of the weight measurement values in the reference period P2 within the rotation speed maintaining period P1.

The storage process unit 66 causes the storage unit 56 to store the rotation speed determined by the rotation speed determination process unit 64 as rotation speed data 60.

When the rotation speed setting process is not in progress, the operation process unit 68 refers to the rotation speed data 60 as necessary and rotates the cooling fan 20 at the rotation speed indicated by the rotation speed data 60.

### 5. Flow

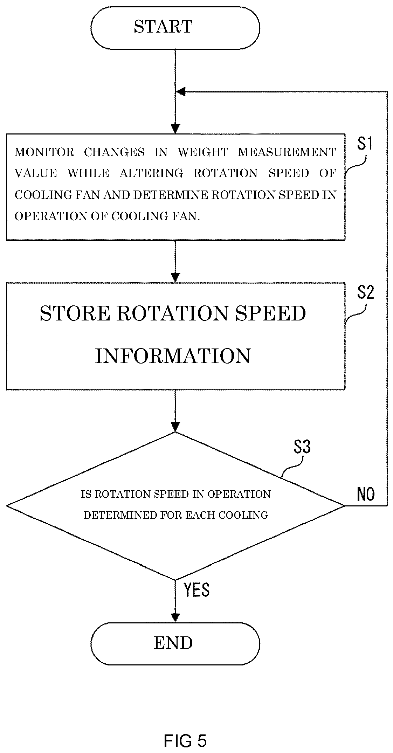

FIG. 5 is a flowchart showing an example of rotation speed setting process of the thermogravimetric measurement apparatus 10 of the present embodiment. The rotation speed setting process may start at any given time as described above.

Step S1 monitors changes in the weight measurement value at the measurement unit 14 while altering the rotation speed of a cooling fan 20 and determines the rotation speed in operation of the cooling fan 20 based on the changes in the weight measurement value.

Specifically, step S1 monitors changes in the weight measurement value at the measurement unit 14 while increasing or decreasing the rotation speed of one of the multiple cooling fans 20 in a stepwise manner with the other cooling fans 20 stopped, and determines the rotation speed in operation of the cooling fan 20 based on the magnitude or average value of the weight measurement values in the reference period P2 within the rotation speed maintaining period P1.

Step S2 causes the storage unit 56 to store information on the rotation speed determined at step S1 as rotation speed information indicating the rotation speed in operation of the cooling fan 20.

Step S3 determines whether the rotation speed in operation is determined for each of the cooling fans 20. If the answer at step S3 is "NO", that is, if the rotation speed in operation is not determined for any of the cooling fans 20, the process returns to step S1 to determine the rotation speed in operation for another cooling fan 20. If the answer at step S3 is "YES", that is, if the rotation speed in operation is determined for all the cooling fans 20, the rotation speed setting process ends.

## Claims

1. A method for setting a thermogravimetric measurement apparatus (10) comprising a measurement unit (14) adapted to measure a weight of a sample, a heating unit (16) adapted to heat the sample, and a cooling fan (20) physically connected to the measurement unit (14), the method **characterized in that** it comprises:
a rotation speed determination step comprising monitoring changes in a weight measurement value at the measurement unit (14) while altering a rotation speed of the cooling fan (20), wherein such monitoring changes in the weight measurement value at the measurement unit are performed in a state in which the sample is not set on the measurement unit (14),
identifing the relationship between the rotation speed of the cooling fan (20) and an amount of noise in the weight measurement value caused by the vibration of the cooling fan (20),
and determining a rotation speed in operation of the cooling fan (20) based on the changes in the weight measurement value.

2. The method according to claim 1, wherein the rotation speed determination step comprises monitoring changes in the weight measurement value at the measurement unit (14) while altering a rotation speed of the cooling fan (20) in a stepwise manner.

3. The method according to claim 2, wherein the rotation speed determination step comprises determining the rotation speed in operation of the cooling fan (20) based on an average value of the weight measurement value in a predetermined period within a period in which a rotation speed of the cooling fan (20) is maintained.

4. The method according to claim 2, wherein the rotation speed determination step comprises determining the rotation speed in operation of the cooling fan (20) based on a magnitude of the weight measurement value in a predetermined period within a period in which a rotation speed of the cooling fan (20) is maintained.

5. The method according to claim 1, wherein
the thermogravimetric measurement apparatus includes a plurality of the cooling fans, and
the rotation speed determination step comprises monitoring changes in the weight measurement value at the measurement unit while altering a rotation speed of one cooling fan of the cooling fans with the other cooling fans stopped.

6. The method according to claim 1, wherein
the thermogravimetric measurement apparatus further comprises a housing having the measurement unit therein, and
the measurement unit and the cooling fan are directly or indirectly attached to the housing so that the cooling fan is physically connected to the measurement unit.

7. A thermogravimetric measurement apparatus (10) comprising:
a measurement unit (14) adapted to measure a weight of a sample;
a heating unit (16) adapted to heat the sample;
a cooling fan (20) physically connected to the measurement unit; and **characterized by**:
a rotation speed determination process unit (64) adapted to monitor changes in a weight measurement value at the measurement unit while altering a rotation speed of the cooling fan, for identifing the relationship between the rotation speed of the cooling fan (20) and an amount of noise in the weight measurement value caused by the vibration of the cooling fan (20), and determining a rotation speed in operation of the cooling fan (20) based on the changes in the weight measurement value,
wherein, such monitoring changes in the weight measurement value at the measurement unit (14) are performed in a state in which the sample is not set on the measurement unit (14).

## Patentansprüche

1. Verfahren zum Einstellen einer Vorrichtung (10) zur thermogravimetrischen Messung, umfassend eine Messeinheit (14), die ausgelegt ist, um ein Gewicht einer Probe zu messen, eine Heizeinheit (16), die ausgelegt ist, um die Probe zu erhitzen, und ein Kühlgebläse (20), das physisch mit der Messeinheit (14) verbunden ist, wobei das Verfahren **dadurch gekennzeichnet ist, dass** es Folgendes umfasst:
einen Drehzahlbestimmungsschritt, umfassend Überwachen von Änderungen in einem Gewichtsmesswert an der Messeinheit (14), während eine Drehzahl des Kühlgebläses (20) geändert wird, wobei ein derartiges Überwachen von Änderungen in dem Gewichtsmesswert an der Messeinheit in einem Zustand durchgeführt wird, in dem die Probe sich nicht auf der Messeinheit (14) befindet,
Identifizieren der Beziehung zwischen der Drehzahl des Kühlgebläses (20) und einem Ausmaß an Rauschen in dem Gewichtsmesswert, das durch die Schwingungen des Kühlgebläses (20) verursacht wird,
und Bestimmen einer Drehzahl in Betrieb des Kühlgebläses (20) basierend auf den Änderungen des Gewichtsmesswerts.

2. Verfahren nach Anspruch 1, wobei der Drehzahlbestimmungsschritt das Überwachen von Änderungen in dem Gewichtsmesswert an der Messeinheit (14) umfasst, während eine Drehzahl des Kühlgebläses (20) auf schrittweise Art geändert wird.

3. Verfahren nach Anspruch 2, wobei der Drehzahlbestimmungsschritt das Bestimmen der Drehzahl im Betrieb des Kühlgebläses (20) basierend auf einem Mittelwert des Gewichtsmesswerts in einem vorbestimmten Zeitraum innerhalb eines Zeitraums, in dem eine Drehzahl des Kühlgebläses (20) beibehalten wird, umfasst.

4. Verfahren nach Anspruch 2, wobei der Drehzahlbestimmungsschritt das Bestimmen der Drehzahl im Betrieb des Kühlgebläses (20) basierend auf einer Größe des Gewichtsmesswerts in einem vorbestimmten Zeitraum innerhalb eines Zeitraums, in dem eine Drehzahl des Kühlgebläses (20) beibehalten wird, umfasst.

5. Verfahren nach Anspruch 1, wobei die Vorrichtung zur thermogravimetrischen Messung eine Vielzahl der Kühlgebläse umfasst und
der Drehzahlbestimmungsschritt das Überwachen von Änderungen in dem Gewichtsmesswert an der Messeinheit umfasst, während eine Drehzahl eines Kühlgebläses aus den Kühlgebläsen geändert wird, wobei die anderen Kühlgebläse angehalten werden.

6. Verfahren nach Anspruch 1, wobei die Vorrichtung zur thermogravimetrischen Messung weiters ein Gehäuse umfasst, dass die Messeinheit darin aufweist, und
die Messeinheit und das Kühlgebläse direkt oder indirekt an dem Gehäuse angebracht sind, sodass das Kühlgebläse physisch mit der Messeinheit verbunden ist.

7. Vorrichtung (10) zur thermogravimetrischen Messung, umfassend:
eine Messeinheit (14), die ausgelegt ist, um ein Gewicht einer Probe zu messen;
eine Heizeinheit (16), die ausgelegt ist, um die Probe zu erhitzen;
ein Kühlgebläse (20), das physisch mit der Messeinheit verbunden ist; und durch Folgendes gekennzeichnet ist:
eine Drehzahlbestimmungsverfahrenseinheit (64), die ausgelegt ist, um Änderungen in einem Gewichtsmesswert an der Messeinheit zu überwachen, während eine Drehzahl des Kühlgebläses geändert wird, zum Identifizieren der Beziehung zwischen der Drehzahl des Kühlgebläses (20) und einem Ausmaß an Rauschen in dem Gewichtsmesswert, das durch die Schwingungen des Kühlgebläses (20) verursacht wird, und zum Bestimmen einer Drehzahl in Betrieb des Kühlgebläses (20) basierend auf den Änderungen des Gewichtsmesswerts,
wobei ein derartiges Überwachen von Änderungen in dem Gewichtsmesswert an der Messeinheit (14) in einem Zustand durchgeführt wird, in dem die Probe sich nicht auf der Messeinheit (14) befindet.

## Revendications

1. Procédé de réglage d'un appareil de mesure thermogravimétrique (10) comprenant une unité de mesure (14) adaptée pour mesurer un poids d'un échantillon, une unité de chauffage (16) adaptée pour chauffer l'échantillon, et un ventilateur de refroidissement (20) connecté physiquement à l'unité de mesure (14), le procédé étant **caractérisé en ce qu'**il comprend :
une étape de détermination de vitesse de rotation comprenant une surveillance des changements dans une valeur de mesure de poids au niveau de l'unité de mesure (14) tout en modifiant une vitesse de rotation du ventilateur de refroidissement (20), dans lequel de tels changements de surveillance dans la valeur de mesure de poids au niveau de l'unité de mesure sont effectués dans un état dans lequel l'échantillon n'est pas réglé sur l'unité de mesure (14),
une identification de la relation entre la vitesse de rotation du ventilateur de refroidissement (20) et une quantité de bruit dans la valeur de mesure de poids causée par la vibration du ventilateur de refroidissement (20), et
une détermination d'une vitesse de rotation lors du fonctionnement du ventilateur de refroidissement (20) sur la base des changements de la valeur de mesure de poids.

2. Procédé selon la revendication 1, dans lequel l'étape de détermination de vitesse de rotation comprend une surveillance de changements dans la valeur de mesure de poids au niveau de l'unité de mesure (14) tout en modifiant une vitesse de rotation du ventilateur de refroidissement (20) d'une manière progressive.

3. Procédé selon la revendication 2, dans lequel l'étape de détermination de vitesse de rotation comprend une détermination de la vitesse de rotation lors du fonctionnement du ventilateur de refroidissement (20) sur la base d'une valeur moyenne de la valeur de mesure de poids dans une période prédéterminée dans une période dans laquelle une vitesse de rotation du ventilateur de refroidissement (20) est maintenue.

4. Procédé selon la revendication 2, dans lequel l'étape de détermination de vitesse de rotation comprend une détermination de la vitesse de rotation lors du fonctionnement du ventilateur de refroidissement (20) sur la base d'une amplitude de la valeur de mesure de poids dans une période prédéterminée dans une période dans laquelle une vitesse de rotation du ventilateur de refroidissement (20) est maintenue.

5. Procédé selon la revendication 1, dans lequel
l'appareil de mesure thermogravimétrique inclut une pluralité de ventilateurs de refroidissement, et
l'étape de détermination de vitesse de rotation comprend une surveillance de changements dans la valeur de mesure de poids au niveau de l'unité de mesure tout en modifiant une vitesse de rotation d'un certain ventilateur de refroidissement des ventilateurs de refroidissement en ayant les autres ventilateurs de refroidissement arrêtés.

6. Procédé selon la revendication 1, dans lequel
l'appareil de mesure thermogravimétrique comprend en outre un boîtier présentant l'unité de mesure en son sein, et
l'unité de mesure et le ventilateur de refroidissement sont directement ou indirectement fixés au boîtier de sorte que le ventilateur de refroidissement est connecté physiquement à l'unité de mesure.

7. Appareil de mesure thermogravimétrique (10), comprenant :
une unité de mesure (14) adaptée pour mesurer un poids d'un échantillon ;
une unité de chauffage (16) adaptée pour chauffer l'échantillon ;
un ventilateur de refroidissement (20) connecté physiquement à l'unité de mesure ; et **caractérisé par** :
une unité de traitement de détermination de vitesse de rotation (64) adaptée pour surveiller des changements d'une valeur de mesure de poids au niveau de l'unité de mesure tout en modifiant une vitesse de rotation du ventilateur de refroidissement, pour identifier la relation entre la vitesse de rotation du ventilateur de refroidissement (20) et une quantité de bruit dans la valeur de mesure de poids causée par la vibration du ventilateur de refroidissement (20), et déterminer une vitesse de rotation lors du fonctionnement du ventilateur de refroidissement (20) sur la base des changements de la valeur de mesure de poids,
dans lequel, la surveillance de tels changements dans la valeur de mesure de poids au niveau de l'unité de mesure (14) sont effectués dans un état dans lequel l'échantillon n'est pas réglé sur l'unité de mesure (14).
